(19)

**Europäisches Patentamt**

**European Patent Office**

**Office européen des brevets**

(11) **EP 4 665 095 A1**

(12) **EUROPEAN PATENT APPLICATION**

published in accordance with Art. 153(4) EPC

(43) Date of publication:
17.12.2025 Bulletin 2025/51

(21) Application number: 23935048.1

(22) Date of filing: 23.11.2023

(51) International Patent Classification (IPC):
**H05K 7/20** (2006.01)

(52) Cooperative Patent Classification (CPC):
**F28D 15/046; F28F 3/022; F28F 3/048; G06F 1/20; H01L 23/3677; H01L 23/427;** F28F 2250/02; F28F 2275/06

(86) International application number:
**PCT/CN2023/133587**

(87) International publication number:
**WO 2024/221880 (31.10.2024 Gazette 2024/44)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: 27.04.2023 CN 202310478530

(71) Applicant: Honor Device Co., Ltd.
Shenzhen, Guangdong 518040 (CN)

(72) Inventors:
• **FU, Guochao**
Shenzhen, Guangdong 518040 (CN)

• **WANG, Shushu**
Shenzhen, Guangdong 518040 (CN)
• **GAO, Xiangzheng**
Shenzhen, Guangdong 518040 (CN)
• **XU, Zhengxuan**
Shenzhen, Guangdong 518040 (CN)
• **YANG, Yuanru**
Shenzhen, Guangdong 518040 (CN)

(74) Representative: **Isarpatent**
**Patent- und Rechtsanwälte**
**Barth Hassa Peckmann & Partner mbB**
**Friedrichstraße 31**
**80801 München (DE)**

(54) **VAPOR CHAMBER AND ELECTRONIC DEVICE**

(57) This application provides a vapor chamber and an electronic device. The vapor chamber includes: a first housing and a second housing, where the first housing is sealingly connected to the second housing, and an accommodating cavity is formed between the first housing and the second housing; and support columns, where the support columns are fixed between the first housing and the second housing, a position on the first housing close to a heat source is an evaporation end, a position on the first housing away from the heat source is a condensation end, and a length of a cross section of at least part of the support columns is greater in a first direction than in a second direction, where the first direction is a direction from the evaporation end to the condensation end, and the second direction is perpendicular to the first direction. The cross section of the at least part of the support columns is configured to be in a shape that is longer in the direction from the evaporation end to the condensation end, so that a gas working medium flowing from the evaporation end to the condensation end can be guided, so as to reduce flow resistance of the support column to the flowing gas working medium, and ensure efficiency of gas and liquid circulation, thereby ensuring a heat dissipation effect.

EP 4 665 095 A1

FIG. 19

## Description

This application claims priority to Chinese Patent Application No. 202310478530.6, filed with the China National Intellectual Property Administration on April 27, 2023 and entitled "VAPOR CHAMBER AND ELECTRONIC DEVICE", which is incorporated herein by reference in its entirety.

## TECHNICAL FIELD

This application relates to the field of electronic devices, and in particular, to a vapor chamber and an electronic device.

## BACKGROUND

Generally, a vapor chamber (Vapor chamber, VC for short) may also be referred to as a temperature equalizing plate, a super thermal conduction plate, or a thermal conduction plate. As a highly efficient heat dissipation component, the vapor chamber is widely used in an integrated device.

The vapor chamber includes a first housing, a second housing, and a capillary structure. The first housing is sealingly connected to the second housing, the capillary structure is located on the second housing, support columns for supporting the first housing and the capillary structure are provided on a side of the first housing close to the second housing, and a vapor passage allowing flow of a gas working medium is formed between adjacent support columns.

When a distance between the first housing and the second housing is determined, a height of the support column is determined. To enhance strength of the vapor chamber, a cross-sectional area of the support column may be increased. However, the increase in the cross-sectional area of the support column increases resistance to the flow of the gas working medium. This affects efficiency of gas and liquid circulation, and therefore, affects a heat dissipation effect.

Therefore, how to reduce resistance of the support column to the flow of the gas working medium, to ensure the efficiency of the gas and liquid circulation, so as to ensure the heat dissipation effect is a technical problem to be urgently resolved by a person skilled in the art.

## SUMMARY

This application provides a vapor chamber, to ensure efficiency of gas and liquid circulation, so as to ensure a heat dissipation effect. In addition, this application further provides an electronic device including the vapor chamber.

To achieve the foregoing objective, this application provides the following technical solutions.

According to a first aspect, this application provides a vapor chamber, including: a first housing and a second housing, where the first housing is sealingly connected to the second housing and an accommodating cavity is formed between the first housing and the second housing; and support columns, where the support columns are fixed between the first housing and the second housing, a position on the first housing close to a heat source is an evaporation end, and a position on the first housing away from the heat source is a condensation end. A length of a cross section of at least part of the support columns is greater in a first direction than in a second direction, where the first direction is a direction from the evaporation end to the condensation end, and the second direction is perpendicular to the first direction.

It can be learned from the foregoing content that the cross section of the at least part of the support columns is configured to be in a shape that is longer in the direction from the evaporation end to the condensation end, so that a gas working medium flowing from the evaporation end to the condensation end can be guided, so as to reduce flow resistance of the support column to the flowing gas working medium, and ensure efficiency of gas and liquid circulation, thereby ensuring a heat dissipation effect.

In a possible implementation, the support column having a cross section of which the length is greater in the first direction than in the second direction satisfies: a width of the support column first increases and then decreases in the first direction.

It can be learned from the foregoing content that the cross section of the support column is configured so that the width first increases and then decreases in the first direction, so that the support column is in a streamlined shape. This helps the support column guide the gas working medium, so as to reduce the flow resistance of the support column to the flowing gas working medium, and ensure the efficiency of the gas and the liquid circulation, thereby ensuring the heat dissipation effect.

In a possible implementation, the support columns include: first support columns, where the first support column is located at the evaporation end of the first housing; second support columns, where the second support column is located at a middle segment between the evaporation end and the condensation end, and a length of a cross section of the second support column is greater in the first direction than in the second direction; and third support columns, where the third support column is located at the condensation end of the first housing.

In a possible implementation, the first support columns and the second support columns are arranged side by side in the first direction, and the third support columns are arranged in a staggered manner in the first direction and/or the second direction.

It can be learned from the foregoing content that the first support columns and the second support columns are arranged side by side, so that resistance to the gas working medium can be reduced. The third support columns are arranged in a staggered manner, so that heat exchange efficiency of the condensation end can be improved, thereby ensuring the heat dissipation effect.

In a possible implementation, a length of a cross section of the first support column and/or a length of a cross section of the third support column are/is greater in the first direction than in the second direction.

It can be learned from the foregoing content that increasing a quantity of support columns for flow guide further improves the heat exchange efficiency of the condensation end, thereby ensuring the heat dissipation effect.

In a possible implementation, at least one of the first support column, the second support column, and the third support column satisfies: a width first increases and then decreases in the first direction.

In a possible implementation, at least one of the first support column, the second support column, and the third support column is an airfoil-shaped support column, and a cross section of the airfoil-shaped support column includes: a leading edge and a trailing edge, where both the leading edge and the trailing edge are arc surfaces, an opening angle of the leading edge is greater than an opening angle of the trailing edge, and the leading edge faces the heat source; and a first side and a second side, where the first side and the second side are respectively located at two sides of the leading edge and the trailing edge and connect the leading edge and the trailing edge.

It can be learned from the foregoing content that use of the airfoil-shaped support column facilitates reduction of the resistance of the support column to the gas working medium, so as to ensure the efficiency of the gas and liquid circulation, thereby ensuring the heat dissipation effect.

In a possible implementation, a chord length H of the cross section of the airfoil-shaped support column and a maximum thickness D of the airfoil-shaped support column satisfy: D/H=0.05-0.95.

In a possible implementation, at least one of the first support column, the second support column, and the third support column is a tapered support column, and a cross section of the tapered support column includes: a first guide segment, a first connection segment, and a second guide segment that are connected in sequence, where in a direction from the first guide segment to the second guide segment, a width of the first guide segment gradually increases, a width of the second guide segment gradually decreases, and a width of the first connection segment is equal, and the first guide segment faces the heat source.

It can be learned from the foregoing content that use of the tapered support column facilitates reduction of the resistance of the support column to the gas working medium, so as to ensure the efficiency of the gas and liquid circulation, thereby ensuring the heat dissipation effect.

In a possible implementation, the first guide segment is triangular, and a third guide segment is semi-elliptic or triangular.

In a possible implementation, a cone angle of the first guide segment ranges from 20° to 80°.

In a possible implementation, in directions from the middle to two sides of the first housing in the second direction, a length of the vapor passage formed between adjacent second support columns in the first direction gradually increases.

It can be learned from the foregoing content that a change is made to the length of the vapor passages formed between the adjacent second support columns in the first direction to make resistance at two ends of the condensation end and the evaporation end different, so as to facilitate diffusion of the gas working medium, and make the gas working medium be distributed more evenly, thereby effectively improving the heat exchange efficiency.

In a possible implementation, in the directions from the middle to two sides of the first housing in the second direction, lengths of the second support columns gradually increase.

It can be learned from the foregoing content that a length of the second support column in the first direction is changed, so that the length of the vapor passage is changed.

In a possible implementation, ends of a plurality of second support columns close to the first support column are flush, or a line connecting ends of a plurality of second support columns close to the first support column is V-shaped.

It can be learned from the foregoing content that a change is made to an arrangement position of the second support column in the first direction to facilitate diffusion of the gas working medium in the second direction, and make the gas working medium be distributed more evenly, thereby effectively improving the heat exchange efficiency.

In a possible implementation, the first support columns are evenly arranged in the first direction, and the third support columns are arranged in a staggered manner at the condensation end.

In a possible implementation, a density of the support columns gradually decreases in a direction away from the heat source.

It can be learned from the foregoing content that a change is made to sealing of the support column to make resistance at the evaporation end large and resistance at the condensation end small, so as to facilitate diffusion of the gas working medium from the evaporation end to the condensation end, and make the gas working medium be distributed more evenly, thereby effectively improving the heat exchange efficiency.

In a possible implementation, a size of the support column gradually decreases in the direction away from the heat source.

It can be learned from the foregoing content that a change is made to sealing of the support column to make resistance at the evaporation end large and resistance at the condensation end small, so as to facilitate diffusion of the gas working medium from the evaporation end to the condensation end, and make the gas working medium be distributed more evenly, thereby effectively improving the heat exchange efficiency.

In a possible implementation, a capillary structure is further included, and the capillary structure is located in the accommodating cavity.

According to a second aspect, this application provides an electronic device, including a vapor chamber, where the vapor chamber is the foregoing vapor chamber.

It can be learned from the foregoing content that because the electronic device includes the foregoing disclosed vapor chamber, the electronic device also has all the foregoing technical effects. Details are not described herein again.

**BRIEF DESCRIPTION OF DRAWINGS**

FIG. 1 is an exploded side view of a mobile phone according to conventional technologies;

FIG. 2 is an exploded front view of a middle frame and a vapor chamber of a mobile phone according to conventional technologies;

FIG. 3 is a front cross-sectional view of a vapor chamber according to conventional technologies;

FIG. 4 is a schematic diagram of a structure of a first housing according to conventional technologies;

FIG. 5 is a front view of a first structure of a first housing according to an embodiment of this application;

FIG. 6 is a front view of a second structure of a first housing according to an embodiment of this application;

FIG. 7 is a front view of a third structure of a first housing according to an embodiment of this application;

FIG. 8 is a schematic diagram of a structure of an airfoil-shaped support column according to an embodiment of this application;

FIG. 9 is a schematic diagram of a fourth structure of a first housing according to an embodiment of this application;

FIG. 10 is a schematic diagram of a structure of a spindle-shaped support column according to an embodiment of this application;

FIG. 11 is a schematic diagram of a fifth structure of a first housing according to an embodiment of this application;

FIG. 12 is a schematic diagram of a structure of a double-taper support column according to an embodiment of this application;

FIG. 13 is a simulation diagram of velocity vectors and pressure gradients corresponding to support columns of different shapes according to an embodiment of this application;

FIG. 14 is a schematic diagram of a sixth structure of a first housing according to an embodiment of this application;

FIG. 15 is a schematic diagram of a seventh structure of a first housing according to an embodiment of this application;

FIG. 16 is a schematic diagram of an eighth structure of a first housing according to an embodiment of this application;

FIG. 17 is a schematic diagram of a ninth structure of a first housing according to an embodiment of this application;

FIG. 18 is a schematic diagram of a tenth structure of a first housing according to an embodiment of this application;

FIG. 19 is a schematic diagram of an eleventh structure of a first housing according to an embodiment of this application;

FIG. 20 is a schematic diagram of a twelfth structure of a first housing according to an embodiment of this application;

FIG. 21 is a schematic diagram of a thirteenth structure of a first housing according to an embodiment of this application; and

FIG. 22 is a schematic diagram of a fourteenth structure of a first housing according to an embodiment of this application.

**DESCRIPTION OF EMBODIMENTS**

Terms used in the following embodiments are merely intended to describe specific embodiments, but are not intended to limit this application. As used in the specification and the appended claims of this application, the singular expressions "a/an", "one", "said", "the above", "the", and "this" are intended to include such expressions as "one or more", unless otherwise clearly indicated in the context. It should be further understood that, in embodiments of this application, "one or more" means one, two, or more. "and/or" describes an association relationship between associated objects and represents that three relationships may exist. For example, A and/or B may represent: only A exists, both A and B exist, and only B exists, where A and B may be singular or plural. The character "/" in this specification generally indicates an "or" relationship between the associated objects.

Reference to "an embodiment", "some embodiments", or the like described in this specification means that one or more embodiments of this application include a specific feature, structure, or characteristic described with reference to embodiments. Therefore, statements, for example, "in an embodiment", "in some embodiments", "in some other embodiments", and "in other embodiments" that appear at different places in this specification do not necessarily mean referring to a same embodiment. Instead, the statements mean "one or more but not all of embodiments", unless otherwise specifically emphasized in another manner. The terms "include", "have", and their variants all mean "include but are not limited to", unless otherwise specifically emphasized in another manner.

A plurality of involved in embodiments of this application refers to two or more. It should be noted that, in descriptions of embodiments of this application, terms such as "first" and "second" are merely used for distinguishing descriptions, and cannot be understood as an indication or implication of relative importance, or an indication or implication of a sequence.

With the development of device integration, heat of a device tends to accumulate. This causes a sharp increase in the heat flux density of an integrated device. A high heat flux affects reliability of the integrated device, and results in poor thermal experience for a user. Therefore, effective thermal management has become a hot topic in recent years.

Generally, a vapor chamber (Vapor chamber, VC for short) may also be referred to as a temperature equalizing plate, a super thermal conduction plate, or a thermal conduction plate. As a highly efficient heat dissipation component, the vapor chamber is widely used in an integrated device. The integrated device is referred to as an electronic device in the following content. The electronic device is, for example, a mobile phone, a tablet computer, or a notebook computer.

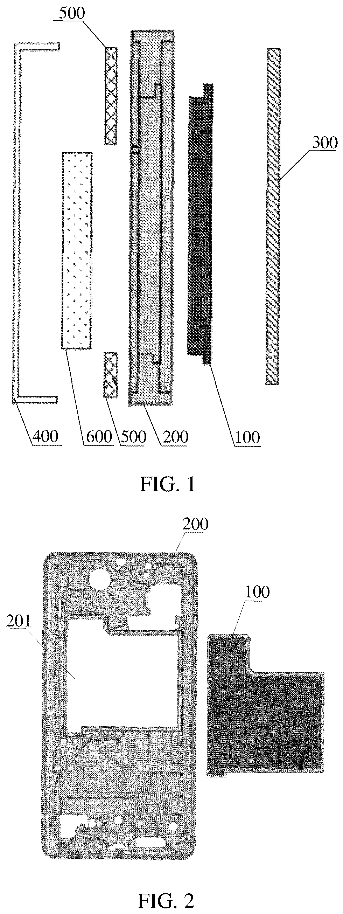

The following describes application of a vapor chamber in an electronic device in detail by using a mobile phone as an example with reference to FIG. 1 and FIG. 2. FIG. 1 is an exploded side view of the mobile phone, and FIG. 2 is a exploded front view of a middle frame and a vapor chamber of the mobile phone.

As shown in FIG. 1, the mobile phone includes a display 300, a vapor chamber 100, a middle frame 200, a circuit board 500, a battery 600, and a rear housing 400.

The display 300 and the rear housing 400 are respectively fixed on two sides of the middle frame 200. The vapor chamber 100 is fixed on the middle frame 200. The circuit board 500 and the battery 600 are mounted between the middle frame 200 and the rear housing 400. Optionally, the vapor chamber 100 may be mounted on a side of the middle frame 200 close to the display 300, or may be mounted on a side of the middle frame 200 close to the rear housing 400.

As shown in FIG. 2, the middle frame 200 has a mounting hole 201, and the vapor chamber 100 is mounted in the mounting hole 201 in a connection manner such as clipping, adhesion, or welding, and is fitted with the circuit board 500 in FIG. 1. The vapor chamber 100 dissipates heat from a heat source device on the circuit board 500, to ensure performance stability of the mobile phone.

Specifically, the heat source device on the circuit board 500 includes, but is not limited to, a device such as a system on chip (System on Chip, SOC), a central processing unit (Central Processing Unit, CPU), a graphics processing unit (graphics processing unit, GPU), an inductor, and a fast charging device.

It should be noted that the heat source device on the circuit board 500 may be considered as a heat source 1000 below.

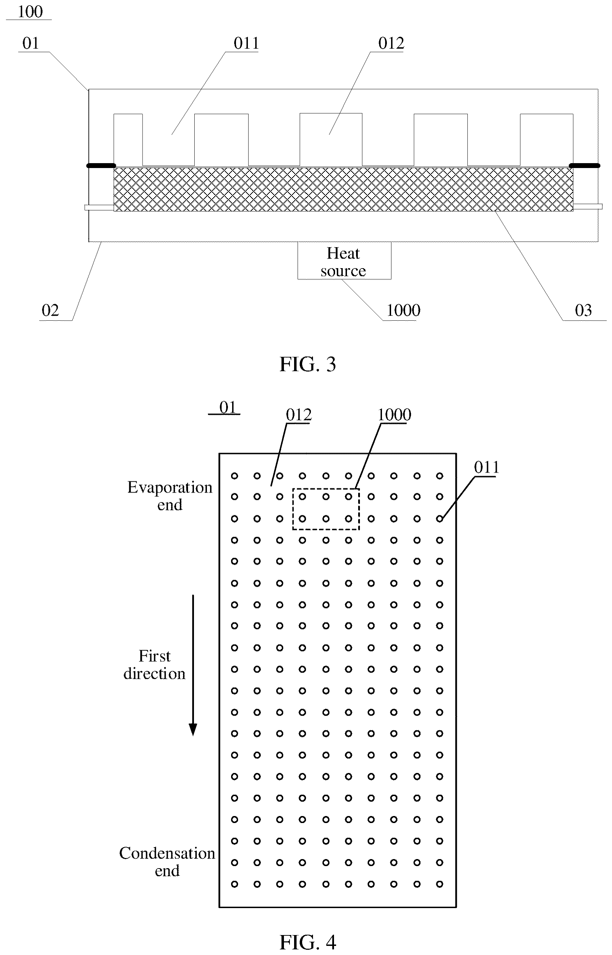

The following describes a heat dissipation principle of a vapor chamber 100 with reference to a specific structure of the vapor chamber 100 shown in FIG. 3 and FIG. 4. FIG. 3 is a front cross-sectional view of a vapor chamber according to the conventional technology, and FIG. 4 is a schematic diagram of a structure of a first housing 01 according to an embodiment of the conventional technology.

As shown in FIG. 3, the vapor chamber 100 includes a first housing 01, a second housing 02, and a capillary structure 03. A side of the first housing 01 close to the second housing 02 has support columns 011 and vapor passages 012.

The first housing 01 is sealingly connected to the second housing 02, for example, by welding. After the first housing 01 and the second housing 02 are connected, a vacuum accommodating cavity is formed between the first housing 01 and the second housing 02. The capillary structure 03 is located in the accommodating cavity. Optionally, the capillary structure 03 is obtained through etching or spot welding for wire mesh on the second housing 02. The accommodating cavity is a flow space for a gas working medium, and the capillary structure 03 is a flow space for a liquid working medium.

The support columns 011 are located in the accommodating cavity, and are abutted against the capillary structure 03, and the vapor passage 012 is formed between adjacent support columns 011. The vapor passage 012 is communicated with the capillary structure 03, to form a circulation channel for a phase-change working medium. The support column 011 may be obtained through etching or stamping on an inner side of the first housing 01.

It should be noted that, in this specification, the phase-change working medium changes into the gas working medium after absorbing heat, and changes into the liquid working medium after dissipating heat. Optionally, the phase-change working medium is water.

When the vapor chamber 100 is assembled with a mobile phone, a side of the second housing 02 away from the first housing 01 is in contact with a heat source 1000. A part of the accommodating cavity faces the heat source 1000 is an evaporation end, and a part of the accommodating cavity away from the heat source 1000 is a condensation end.

During working of the vapor chamber 100, a phase-change working medium at the evaporation end of the vapor chamber 100 absorbs heat generated by the heat source 1000, and changes into a gas working medium. The gas working medium flows to the condensation end along the vapor passage 012, and dissipates heat at the condensation end by external forced convection or under a pressure difference between the evaporation end and the condensation end. After heat dissipation and condensation, the phase-change working medium changes into a liquid working medium, and the liquid working medium flows back to the capillary structure 03. The liquid working medium in the capillary structure 03 flows to the evaporation end under an action of capillary pressure and undergoes a next phase change, so that cyclic cooling is implemented. A cyclic cooling process of the vapor chamber 100 completes continuous and rapid heat dissipation for the heat source 1000.

It should be noted that the support column 011 is disposed between the first housing 01 and the capillary structure 03, to support the first housing 01 and the second housing 02, so as to prevent the vapor passage 012 from being blocked by the vapor chamber 100 due to collapse during vacuuming.

When a distance between the first housing 01 and the second housing 02 is determined, a height of the support column 011 is determined. To improve strength of the vapor chamber 100, a cross-sectional area of the support column 011 may be increased. However, the increase in the cross-sectional area of the support column 011 increases resistance during flow of the gas working medium.

It should be noted that the cross-sectional area in this specification is an area of a cross section of the support column 011 in a radial direction, and may also be understood as a support area of the support column 011.

With reference to a structure of the first housing 01 shown in FIG. 4, the first housing 01 is simplified into a rectangular member. Resistance of the support column 011 is described below by using an example in which one end of the first housing 01 close to the heat source 1000 is the evaporation end, and the other end of the first housing 01 is the condensation end.

The support columns 011 on the first housing 01 in FIG. 4 are cylinders, and the support columns 011 are evenly arranged on the first housing 01. Therefore, resistance of the support columns 011 at various locations on the first housing 01 to the gas working medium is the same. There are vapor passages 012 between adjacent support columns 011.

It should be noted that the cross section of the support column 011 may alternatively be a square. When the cross section of the support column in this specification is a shape having a sharp corner, such as a rectangle, a square, or a triangle, in a processing process, rounding corner processing is performed in a preferred solution. In some embodiments, in a height direction of the support column 011, a size of the support column 011 may be changed, but a cross-sectional shape of the support column 011 remains unchanged.

In a process of flowing in the gas channel 012, the gas working medium continuously collides with the support column 011, so that the support column 011 generates resistance to the flow of the gas working medium. Under the resistance of the support column 011, a flow velocity of the gas working medium gradually decreases. This increases duration for the gas working medium flows from the evaporation end to the condensation end. In other words, efficiency of gas and liquid circulation is affected, and a heat dissipation effect is further affected.

To reduce the resistance of the support column 011 to the gas working medium, to ensure the efficiency of the gas and liquid circulation, an embodiment of this application provides a support column of a vapor chamber. A cross-sectional shape of the support column and/or an arrangement manner of the support column on the first housing are/is changed, so that the resistance of the support column to the gas working medium is reduced, and vapor in the accommodating cavity is distributed more evenly. This improves the efficiency of the gas and liquid circulation, thereby ensuring the heat dissipation effect.

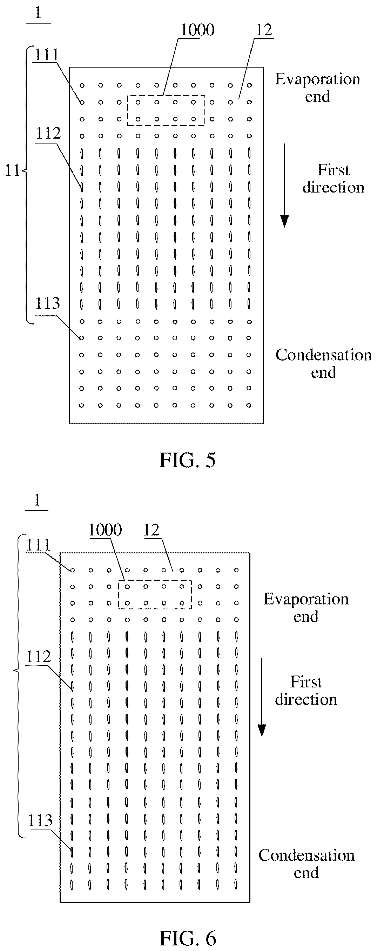

To enable a person skilled in the art to understand the solution of this application more clearly, technical solutions in embodiments of this application are described clearly and completely below with reference to FIG. 5 to FIG. 7 in embodiments of this application.

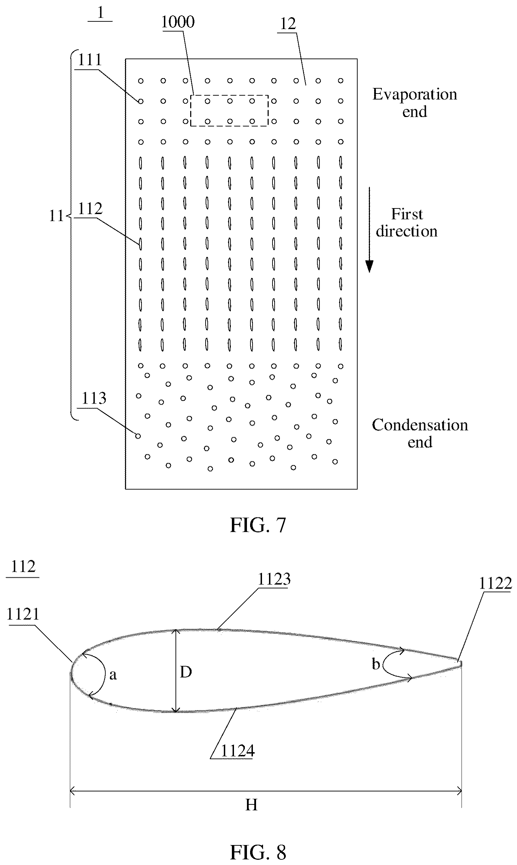

FIG. 5 is a front view of a first structure of a first housing according to an embodiment of this application. FIG. 6 is a front view of a second structure of a first housing according to an embodiment of this application. FIG. 7 is a front view of a third structure of a first housing according to an embodiment of this application.

As shown in FIG. 5 to FIG. 7, one end of the first housing 1 close to a heat source 1000 is an evaporation end, the other end of the first housing 1 is a condensation end, and a middle segment is provided between the evaporation end and the condensation end of the first housing 1. For all embodiments in this specification, refer to this description.

Support columns 11 include first support columns 111, second support columns 112, and third support columns 113. The first support columns 111 are located at the evaporation end, the third support columns 113 are located at the condensation end, and the second support columns 112 are located at the middle segment. Space between adjacent support columns 11 are vapor passages 12.

As shown in FIG. 5, the first support columns 111 are cylindrical support columns, and are evenly arranged in a rectangular array manner at the evaporation end of the first housing 1. The second support columns 112 are airfoil-shaped support columns, and are evenly arranged in a rectangular array manner at the middle segment of the first housing 1. The third support columns 113 are cylindrical support columns, and are evenly arranged in a rectangular array manner at the condensation end of the first housing 1. The first support columns 111, the second support columns 112, and the third support columns 113 are aligned with each other in a first direction.

The first direction in this specification is a direction of a connection line from the evaporation end to the condensation end of the first housing 1, and a second direction and the first direction are two perpendicular directions on the first housing of the vapor chamber. For all embodiments in this specification, refer to this description.

Because a shape of an airfoil-shaped support column has a guiding function, the second support column 112 is configured as the airfoil-shaped support column. This can reduce flow resistance of the second support column 112 to a gas working medium, increase a flow velocity of the gas working medium, improve efficiency of gas and liquid circulation, and ensure a heat dissipation effect.

As shown in FIG. 6, the first support columns 111 are cylindrical support columns, and are evenly arranged in a rectangular array manner at the evaporation end of the first housing 1. The second support columns 112 are airfoil-shaped support columns, and are evenly arranged in a rectangular array manner at the middle segment of the first housing 1. The third support columns 113 are airfoil-shaped support columns, and are evenly arranged in a rectangular array manner at the condensation end of the first housing 1. The first support columns 111, the second support columns 112, and the third support columns 113 are aligned with each other in a first direction.

In this embodiment, the second support column 112 and the third support column 113 are both configured as the airfoil-shaped support columns. Under a guiding function of the airfoil-shaped support columns, flow resistance of the support column 11 to a gas working medium can be further reduced, a flow velocity of the gas working medium is increased, efficiency of gas and liquid circulation is improved, and a heat dissipation effect is ensured.

In conclusion, in the embodiments shown in FIG. 5 and FIG. 6, a shape of the support column 11 is changed to reduce the resistance of the support column 11 to the gas working medium. In some embodiments, an arrangement manner of the support column 11 may be further changed, to reduce the resistance of the support column 11 to the gas working medium.

As shown in FIG. 7, the first support columns 111 are cylindrical support columns, and are evenly arranged in a rectangular array manner at the evaporation end of the first housing 1. The second support columns 112 are airfoil-shaped support columns, and are evenly arranged in a rectangular array manner at the middle segment of the first housing 1. The third support columns 113 are cylindrical support columns, and are arranged in a staggered manner at the condensation end of the first housing 1. The first support columns 111 and the second support columns 112 are arranged side by side in a first direction.

It should be noted that being arranged in the staggered manner means that a third support column 113 in a next row is aligned with a gap between third support columns 113 in a previous row. Certainly, being arranged in the staggered manner may alternatively mean that a third support column 113 in one of two adjacent columns is aligned with a gap between third support columns 113 in the other column. In other words, the third support columns 113 are arranged in the staggered manner in the first direction and/or the second direction.

Because the third support column 113 is located at the condensation segment, a gas working medium is about to condense into liquid. Therefore, a flow velocity of the gas working medium flowing to the condensation end is already very low. In this case, reducing resistance does not significantly improve performance of the vapor chamber.

Based on the foregoing phenomenon, a staggered arrangement of the third support columns 113 may cause the gas working medium to generate turbulent flow at the condensation end, which is also called turbulence. Based on a principle that when fluid flows turbulently, particles of the fluid move irregularly, and various quantities in a flow field change disorderly with time and space coordinates, so that a temperature difference between a center of a tube and a tube wall is small, and heat exchange efficiency is high, the staggered arrangement of the third support columns 113 can improve heat exchange efficiency at the condensation end, thereby ensuring a heat dissipation effect.

The second support columns 112 are the airfoil-shaped support columns. A guiding function of the airfoil-shaped support column can be utilized to reduce flow resistance of the second support column 112 to the gas working medium, improve efficiency of gas and liquid circulation, and ensure the heat dissipation effect.

It should be noted that a shape of the support column 11 directly affects flow resistance of the gas working medium in an accommodating cavity of the vapor chamber, leading to a difference in a pressure drop from the evaporation end to the condensation segment. A larger resistance of the support column indicates a higher pressure drop in the accommodating cavity.

The technical effects of the solutions corresponding to the embodiments shown in FIG. 4 to FIG. 6 are described below with reference to a simulation analysis data result.

Setting of a simulation condition: Size of the vapor chamber: 100 mm*30 mm*0.35 mm. A distance between the first housing and the second housing is 0.1 mm. In other words, a size of the accommodating cavity of the vapor chamber is assumed. An entry velocity at which the gas working medium flows into the accommodating cavity is 5 m/s. In other words, an initial velocity at which a liquid working medium inside the vapor chamber is transformed into the gas working medium and flows into the accommodating cavity is assumed. The cross-sectional area of the support columns with different cross-sectional shapes is 0.50265 $mm^2$ (A diameter of the cylindrical support column is 0.8 mm). A pressure drop result obtained through simulation is as follows.

The support columns 01 in the embodiment shown in FIG. 4 are all cylindrical support columns, and it is obtained through simulation analysis that an average pressure drop inside a vapor chamber corresponding to the support column 01 in FIG. 4 is 1183 pa.

The first support columns 111 and the third support columns 112 in the embodiment shown in FIG. 5 are both cylindrical support columns, and the second support columns 112 are airfoil-shaped support columns. It is obtained through simulation analysis that an average pressure drop inside a vapor chamber corresponding to the support column 11 in FIG. 5 is 1174 pa. Compared with the vapor chamber corresponding to FIG. 4, a pressure drop gain is (1174 pa-1183 pa)/1183 pa*100% =7.6%.

The first support columns 111 in the embodiment shown in FIG. 6 are cylindrical support columns, and the second support columns 112 and the third support columns 113 are both airfoil-shaped support columns. It is obtained through simulation analysis that an average pressure drop inside a vapor chamber corresponding to the support column 11 in FIG. 6 is 1168 pa. Compared with the vapor chamber corresponding to FIG. 4, a pressure drop gain is (1183 pa-1168 pa)/1183 pa*100%=12.67%.

In the support columns 11 in the embodiment shown in FIG. 7, the third support columns 113 are arranged in the staggered manner based on the support columns 11 in the embodiment shown in FIG. 5. Therefore, compared with the arrangement manner of the support columns 11 in the embodiment shown in FIG. 5, a pressure drop gain of a vapor chamber corresponding to the support columns 11 in the embodiment shown in FIG. 7 does not greatly change. However, the third support columns 113 are arranged in the staggered manner, so that disturbance of the gas working medium at the condensation segment is increased, and the heat exchange efficiency at the condensation segment is improved.

It can be learned from pressure drop data obtained through simulation that use of the airfoil-shaped support column can effectively reduce the pressure drop and reduce the resistance to the gas working medium, to ensure the heat dissipation effect.

The foregoing describes an effect of using the airfoil-shaped support column. The following describes a shape and a size of the airfoil-shaped support column in this embodiment of this application by using a second support column 112 shown in FIG. 8 as an example. FIG. 8 is a front view of the second support column 112.

As shown in FIG. 8, when the second support column 112 is an airfoil-shaped support column, a cross section of the airfoil-shaped support column includes a leading edge 1121, a trailing edge 1122, a first side 1123, and a second side 1124.

The leading edge 1121 and the trailing edge 1122 are both arc surfaces, an opening angle a of the leading edge 1121 is greater than an opening angle b of the trailing edge 1122, and the first side edge 1123 and the second side edge 1124 may be arc surfaces forming symmetrical connection lines between the leading edge 1121 and the trailing edge 1122. In some embodiments, the first side edge 1123 and the second side edge 1124 may alternatively be arc surfaces having different radians, and one of the first side edge 1123 and the second side edge 1124 is closer to a straight line.

It should be noted that, when the first side 1123 and the second side 1124 are the arc surfaces forming the symmetrical connection lines between the leading edge 1121 and the trailing edge 1122, the second support column 112 is a first airfoil-shaped support. When the first side 1123 and the second side 1124 are not the arc surfaces forming the symmetrical connection lines between the leading edge 1121 and the trailing edge 1122, the second support column 112 is a second airfoil-shaped support column. A user may select a shape of the second support column 112 based on a flow direction of a gas working medium, and higher parallelism between the flow direction of the gas working medium and a side surface of the second support column 112 indicates smaller resistance of the second support column 112.

With reference to FIG. 7, when the second support column 112 is processed on the first housing 1, the leading edge 1121 of the second support column 112 is oriented to the evaporation end of the first housing 1, and the trailing edge 1122 of the second support column 112 is oriented to the condensation end of the first housing 1. It may also be understood that, a center line of the second support columns 112 is parallel to a first direction. When the gas working medium flows to the second support column 112, the gas working medium is guided to two sides of the second support column 112 under a guiding function of the leading edge 1121, and flows to the trailing edge 1122 respectively along the first side 1123 and the second side 1124.

To reduce resistance of the leading edge 1121 to the gas working medium, the opening angle a of the leading edge 1121 may be reduced. Optionally, the leading edge 1121 is an elliptic surface. Compared with the arc surface, a contact area between the leading edge 1121 and the gas working medium may be reduced, so that the resistance of the second support column 112 to the gas working medium is reduced.

It should be noted that smaller opening angles of the leading edge 1121 and the trailing edge 1122 indicate smaller resistance to the gas working medium. Therefore, the opening angle a of the leading edge 1121 and the opening angle b of the trailing edge 1122 may be set as small as possible while satisfying a processing requirement and a support force of the second support column 112.

The opening angles of the leading edge 1121 and the trailing edge 1122 are related to a chord length H and a maximum thickness D of the second support column 112. In other words, the chord length H and the maximum thickness D of the second support column 112 may be considered as a major axis and a minor axis of an ellipse. A relationship between the opening angles of the leading edge 1121 and the trailing edge 1122 may be determined based on the chord length H and the maximum thickness D of the second support column 112.

A relationship between the chord length H and the maximum thickness D of the cross section of the second support column 112 in this specification is: D/H=0.05-0.95.

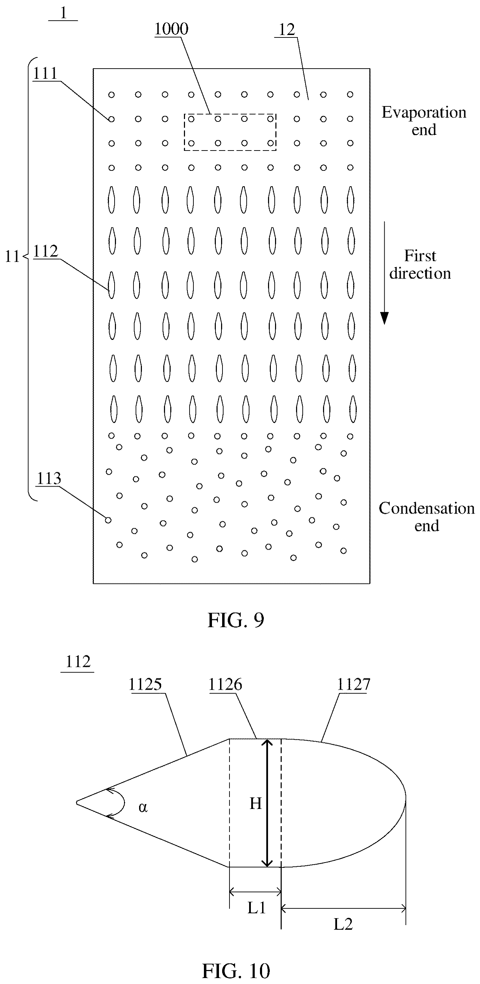

In some embodiments, the foregoing second support column 112 may alternatively be in another shape. For example, the second support column 112 may alternatively be a spindle-shaped support column, a double-taper support column, or an elliptic support column. The following separately describes, with reference to FIG. 9 to FIG. 12, a guiding function in which the second support column 112 is a spindle-shaped support column and a guiding function in which the second support column 112 is a double-taper support column.

FIG. 9 is a schematic diagram of a fourth structure of a first housing, and FIG. 10 is a schematic diagram of a structure in which the second support column 112 is a spindle-shaped support column.

The structure of the first housing 1 shown in FIG. 9 is the same as the structure of the first housing 1 shown in FIG. 7, and a difference lies only in a shape of the second support column 112. Therefore, for the structure of the first housing 1 shown in FIG. 9, refer to the structure of the first housing 1 shown in FIG. 7, and details are not described herein again.

As shown in FIG. 10, when the second support column 112 is the spindle-shaped support column, a cross section of the spindle-shaped support column includes: a first guide segment 1125, a first connection segment 1126, and a second guide segment 1127.

The first guide segment 1125, the first connection segment 1126, and the second guide segment 1127 are sequentially connected to form a whole. Optionally, the second support column 112 is integrally formed, to ensure strength of the second support column 112. The first guide segment 1125 is, but not limited to triangular or trapezoidal. The first connection segment 1126 is rectangular. The second guide segment 1127 is semi-elliptic. In addition, in a direction from the first guide segment 1125 to the second guide segment 1127, a width of the cross section of the second support column 112 first increases and then decreases.

With reference to FIG. 9, when the second support column 112 is processed on the first housing 1, a vertex angle of the first guide segment 1125 is oriented to a first support column 111, and the second guide segment 1127 is oriented to a third support column 113. It may also be understood that, a center line of the second support columns 112 is parallel to a first direction.

Optionally, a cone angle $\alpha$ of the first guide segment 1125 ranges from 20° to 80°. When a gas working medium flowing from an evaporation end to the second support column 112 is in contact with the first guide segment 1125, a contact area between the gas working medium and the second support column 112 can be reduced compared to contacting an arc surface of a cylindrical support column.

It should be noted that, to reduce resistance of the second support column 112 to the gas working medium, a smaller cone angle $\alpha$ of the first guide segment 1125 is preferred. A length L1 of the first connection segment 1126 has small impact on a pressure drop. Therefore, the length of the first connection segment 1126 is not specifically limited. When a horizontal axis length L2 of the second guide segment 1127 is less than a thickness H of the second support column 112, a greater horizontal axis length L2 is preferred.

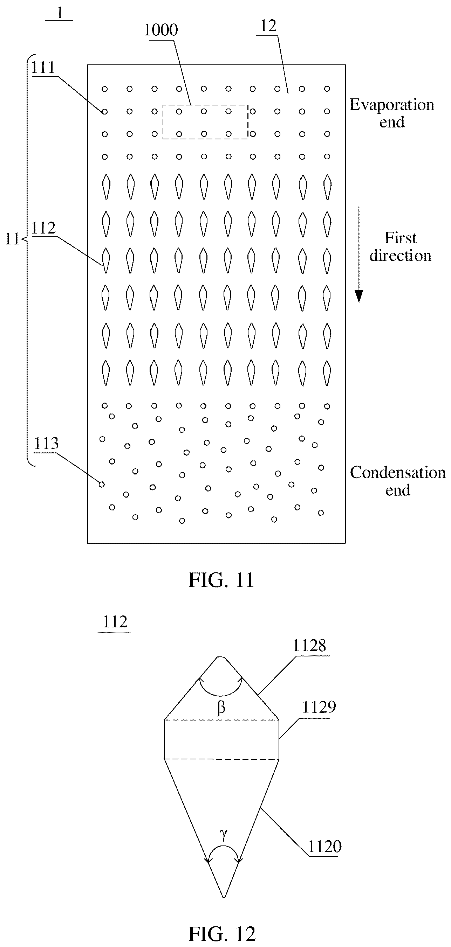

FIG. 11 is a schematic diagram of a fifth structure of a first housing 1, and FIG. 12 is a front view in which the second support column 112 is a double-taper support column.

The structure of the first housing 1 shown in FIG. 11 is the same as the structure of the first housing 1 shown in FIG. 7, and a difference lies only in a shape of the second support column 112. Therefore, for a structure of a vapor chamber shown in FIG. 11, refer to the structure of the vapor chamber shown in FIG. 7, and details are not described herein again.

As shown in FIG. 12, when the second support column 112 is the double-taper support column, a cross section of the double-taper support column includes: a third guide segment 1128, a second connection segment 1129, and a fourth guide segment 1120.

The third guide segment 1128, the second connection segment 1129, and the fourth guide segment 1120 are sequentially connected to form a whole. Optionally, the second support column 112 is integrally formed, to ensure strength of the second support column 112. The third guide segment 1128 is triangular, the second connection segment 1129 is rectangular, and the fourth guide segment 1120 is triangular. In addition, in a direction from the third guide segment 1128 to the fourth guide segment 1120, a thickness of the second support column 112 first increases and then decreases.

With reference to FIG. 11, when the second support column 112 is processed on the first housing 1, a vertex angle of the third guide segment 1128 is oriented to a first support column 111, and the fourth guide segment 1120 is oriented to a third support column 113. It may also be understood that a center line of the second support columns 112 is parallel to a first direction.

Optionally, a cone angle $\beta$ of the third guide segment 1128 and a cone angle $\gamma$ of the fourth guide segment 1120 both range from 20° to 80°. Optionally, a cone angle $\beta$ of the third guide segment 1128 is greater than a cone angle $\gamma$ of the fourth guide segment 1120.

When a gas working medium flowing from an evaporation end to the second support column 112 is in contact with the third guide segment 1128, a contact area between the gas working medium and the second support column 112 can be reduced compared to contacting an arc surface of a cylindrical support column.

It should be noted that, to reduce resistance of the second support column 112 to the gas working medium, a smaller cone angle β of the third guide segment 1128 and a smaller cone angle γ of the fourth guide segment 1120 are preferred.

It can be learned from FIG. 10 and FIG. 12 that a shape of the first guide segment 1125 of the spindle-shaped support column and a shape of the third guide segment 1128 of the double-taper support column are the same. A shape of the first connection segment 1126 of the spindle-shaped support column and a shape of the second connection segment 1129 of the double-taper support column are the same. A difference lies only in that a shape of the second guide segment 1127 and a shape of the fourth guide segment 1120 are different. Therefore, the spindle-shaped support column and the double-taper support column may be generalized as tapered support columns.

It may be understood that the foregoing airfoil-shaped support column, the double-taper support column, and the spindle-shaped support column are all obtained through improvement based on an elliptic support column. Therefore, compared with the cylindrical support column, the elliptic support column can also reduce resistance to a flow of the gas working medium. Further, a rectangular support column can also reduce the resistance to the flow of the gas working medium.

In conclusion, the second support column 112 only needs to satisfy: a length of the second support column 112 is the largest in a direction from an evaporation end to a condensation end, in other words, a length of the second support column 112 is greater in the first direction than in any other direction. In this way, the resistance to the flow of the gas working medium can be reduced.

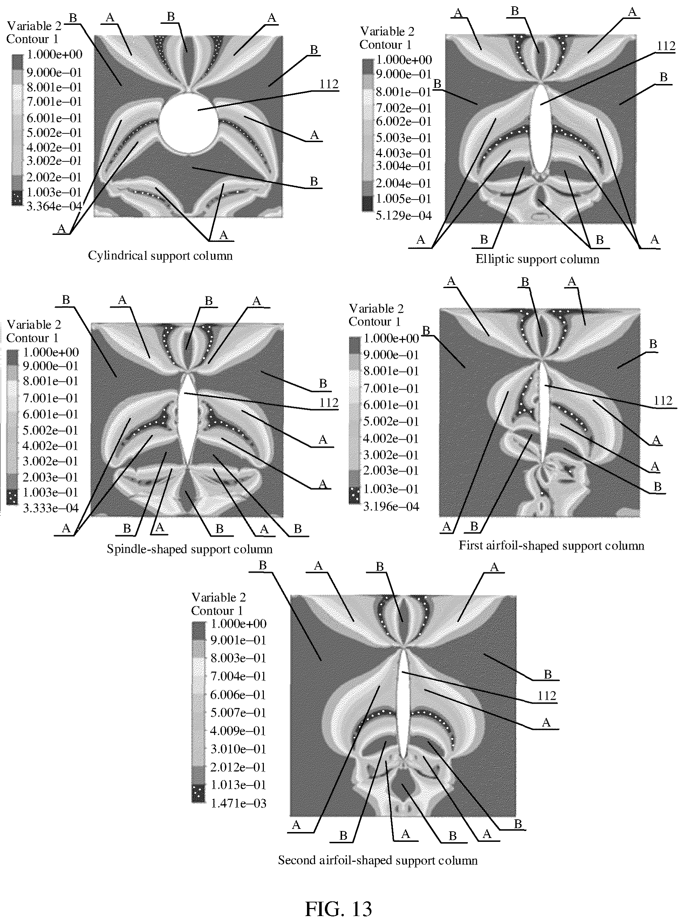

The technical effect of the solution in this application is described below with reference to FIG. 13 with reference to a simulation result when different shapes are selected for the second support column 112. FIG. 13 is a simulation diagram of velocity vectors and pressure gradients corresponding to support columns of different shapes.

When the second support column 112 is separately an elliptic support column, a first airfoil-shaped support column, a second airfoil-shaped support column, a spindle-shaped support column, and a cylindrical support column, a cross-sectional area of the second support column 112 is unchanged.

A region A in FIG. 13 indicates that an angle between a velocity vector of a flow of a gas working medium and a pressure gradient of the gas working medium during flow is close to or equal to 90°, and a region B indicates that an angle between the velocity vector and the pressure gradient of the gas working medium is close to or equal to 0°.

It should be noted that a darker color in the region A indicates that the angle between the velocity vector of the flow of the gas working medium during flow and the pressure gradient of the gas working medium is closer to 90°. A darker color in the region B indicates that the angle between the velocity vector and the pressure gradient of the gas working medium is closer to 0°.

An angular deviation between the velocity vector and the pressure gradient in the region range may be determined by comparing an area of a region B and an area of a region A in a same region range near the second support column 112. A smaller area of a region B indicates a larger angle between the velocity vector and the pressure gradient in a corresponding region.

It can be learned through comparison that when the second support column 112 is the cylindrical support column, an angle between the velocity vector and the pressure gradient of the gas working medium is smaller near the cylindrical support column. In the same region range near the second support column 112, the angle between the velocity vector and the pressure gradient of the gas working medium near the circular support column is smaller than an angle between a velocity vector and a pressure gradient of a double-taper support column, an angle between a velocity vector and a pressure gradient of the first airfoil-shaped support column, and an angle between a velocity vector and a pressure gradient of the second airfoil-shaped support column.

It can be learned in a synergy field principle and a synergy formula of a velocity field and a pressure field that a larger angle between a velocity vector and a pressure gradient indicates a smaller pressure drop and a smaller corresponding flow resistance.

The synergy formula of the velocity field and the pressure field is:

$$\mathrm{Np} = -\vec{u} * \triangledown \mathrm{p} = -|\mathrm{u}||\triangledown \mathrm{p}| * \cos\varphi$$

Np is a pressure drop.

$\triangledown\mathrm{p}$ is a pressure gradient of a flow of a gas working medium.

$\vec{u}$ is a velocity vector of a flow of a gas working medium.

u is a flow velocity of a gas working medium.

φ is an angle between a velocity vector of a flow of a gas working medium and a pressure drop gradient of the gas working medium.

It can be learned with reference to FIG. 13 that in a simulation effect diagram, most regions near the first airfoil-shaped support column and the second airfoil-shaped support column are regions A. Therefore, a pressure drop of the airfoil-shaped support column is the smallest.

To express pressure drop results of the second support column 112 of different shapes more clearly, the following describes the pressure drop results with reference to specific pressure drop data obtained through simulation.

Setting of a simulation condition: Size of a flow space of the gas working medium: 5 mm*5 mm*0.1 mm. In other words, a size of an accommodating cavity of a vapor chamber is assumed. An entry velocity at which the gas working medium flows into the space is 3 m/s. In other words, an initial velocity at which a liquid working medium inside the vapor chamber is transformed into the gas working medium and flows into the accommodating cavity is assumed. The cross-sectional areas of second support columns 112 of different shapes are all set to 0.50265 mm$^2$(A radius of the cylindrical support column=0.8 mm). A simulation analysis is performed on the second support columns 112 having the same cross-sectional area but different shapes. A result of the simulation analysis is as follows.

When the second support column 112 is a cylindrical support column, a pressure drop loss is 4 Pa.

When the second support column 112 is an elliptic support column, a pressure drop loss is 2 Pa.

When the second support column 112 is a double-taper support column, a pressure drop loss is 1.8 Pa.

When the second support column 112 is a first airfoil-shaped support column, a pressure drop loss is 1.5 Pa.

When the second support column 112 is a second airfoil-shaped support column, a pressure drop loss is 1.55 Pa.

In conclusion, on the premise that the cross-sectional areas are the same, compared with the circular support column, the elliptic support column, the airfoil-shaped support column, and the spindle-shaped support column all have an effect of significantly reducing resistance to the flow of the gas working medium. Therefore, all vapor chambers corresponding to these support columns can ensure circulation efficiency, thereby ensuring a heat dissipation effect.

It can be learned from the foregoing content that a manner for ensuring the heat dissipation effect in the foregoing embodiments is: to reduce resistance of a single support column and increase a flow velocity of the gas working medium, so as to improve efficiency of gas and liquid circulation, thereby ensuring the heat dissipation effect. It may be understood that in other embodiments, the second support column 112 may be configured as an airfoil-shaped support column, to reduce resistance to a flow of a gas working medium. In the following embodiments, based on a change of a shape of the second support column 112, another manner is further used to ensure a heat dissipation effect.

In some embodiments, a gas working medium may be distributed more evenly in an accommodating cavity, to improve heat exchange performance, so as to ensure a heat dissipation effect.

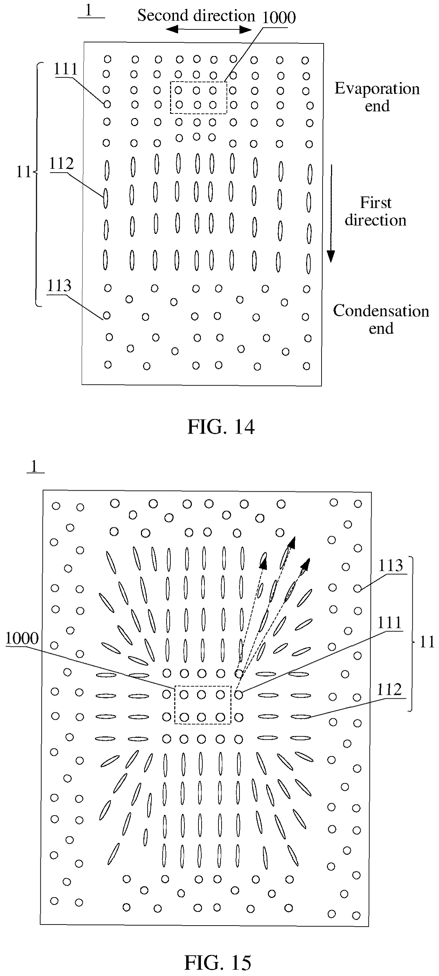

For example, the following describes a manner in the embodiment shown in FIG. 14 in which a gas working medium may be distributed more evenly in an accommodating cavity, to improve heat exchange performance, so as to ensure a heat dissipation effect. FIG. 14 is a schematic diagram of a sixth structure of a first housing.

As shown in FIG. 14, the structure of the first housing 1 is the same as the structure of the first housing 1 shown in FIG. 7, and a difference lies in that in a second direction, a spacing between support columns 11 increases as a distance between the support columns 11 and a heat source 1000 increases. Optionally, in a first direction, a spacing between support columns 11 increases as a distance between the support columns 11 and a heat source 1000 increases.

The heat source 1000 is close to a middle position on an evaporation end of the first housing 1, and in the first direction and the second direction, first support columns 111, second support columns 112, and third support columns 113 all satisfy: a density of support columns close to the heat source 1000 is larger than a density of support columns away from the heat source 1000.

The density of the support columns 11 close to the heat source 1000 is larger, and a larger density indicates larger resistance to a flow of a gas working medium. The density of the support columns 11 away from the heat source 1000 is smaller, and a smaller density indicates smaller resistance to a flow of a gas working medium. It can be learned in a principle that a gas diffuses to a position with smaller resistance, the gas working medium may quickly diffuse from a position close to the heat source 1000 to a direction away from the heat source 1000, ensuring that the gas working medium can quickly fill an accommodating cavity of a vapor chamber. Therefore, by using a distribution manner in which the density of the support columns 11 is different, the gas working medium can be diffused more evenly from the evaporation end to a condensation end, and the gas working medium is distributed more widely. The gas working medium is distributed more widely, so that a heat exchange area is larger, thereby ensuring the heat dissipation effect.

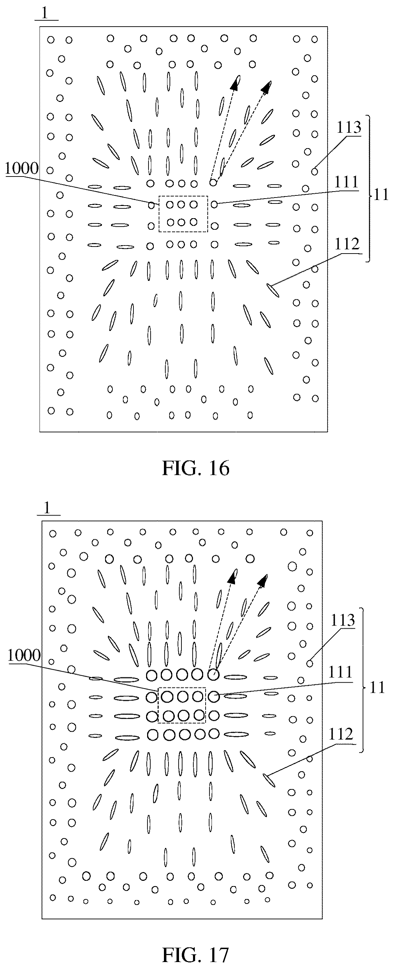

In the foregoing embodiment, the heat source 1000 is located at an end of the vapor chamber. In some embodiments, the heat source 1000 may alternatively be located at a middle part of the vapor chamber. The following describes, with reference to FIG. 15 to FIG. 17, an arrangement manner of the support columns 11 when the heat source 1000 is located at a middle part of the vapor chamber. FIG. 15 is a schematic diagram of a seventh structure of a first housing. FIG. 16 is a schematic diagram of an eighth structure of a first housing. FIG. 17 is a schematic diagram of a ninth structure of a first housing.

Refer to FIG. 15 to FIG. 17. A heat source 1000 is close to a middle position on the first housing 1. In this case, the middle position on the first housing 1 is an evaporation end, a peripheral outer edge position on the first housing 1 is a condensation end, and a middle segment is provided between the evaporation end and the condensation end.

First support columns 111 are disposed at the evaporation end, second support columns 112 are disposed at the middle segment, and third support columns 113 are disposed at the condensation end. The first support columns 111 and the third support columns 113 are both cylindrical support columns, and the second support columns 112 are airfoil-shaped support columns.

As shown in FIG. 15, to reduce resistance in a process in which a gas working medium flows from the evaporation end to the condensation end, a center line of the second support columns 112 is arranged in a direction of the flow of the gas. Resistance of the support column 11 to the flow process of the gas working medium is reduced, so that a flow velocity of the gas working medium can be increased, and efficiency of gas and liquid circulation can be improved, thereby ensuring a heat dissipation effect.

It should be noted that the direction of the flow of the gas in this specification is a connection direction from the evaporation end to the condensation end. In other words, a first direction in FIG. 15 is a divergent direction outward with the heat source 1000 as a center of a circle.

As shown in FIG. 16, a center line of the second support columns 112 is arranged in a direction of the flow of the gas, and a density of the first support columns 111 and a density of the second support columns 112 both satisfy: the density gradually decreases from the evaporation end to the condensation end with the heat source 1000 as a center. In other words, the first housing 1 in the embodiment shown in FIG. 16 reduces resistance of a single support column to a flow process of a gas working medium, so that the gas working medium is distributed more evenly in an evaporation cavity, and efficiency of gas and liquid circulation is improved, thereby ensuring a heat dissipation effect.

It should be noted that, regardless of a position at which the heat source 1000 is located relative to the vapor chamber and regardless of a shape of the vapor chamber, the efficiency of the gas and liquid circulation can be improved in a manner of reducing the resistance of the support column 11 to the flow process of the gas working medium and distributing the gas working medium more evenly in the evaporation cavity.

In all of the foregoing embodiments, a manner for changing a shape of the support column 11 and/or a layout of the support columns 11 is used to ensure the heat dissipation effect. In some embodiments, a cross-sectional area of the support column may alternatively be changed to ensure the heat dissipation effect.

The following describes, with reference to the first housing shown in FIG. 17, a manner for changing a cross-sectional area of the support column to ensure a heat dissipation effect.

As shown in FIG. 17, the cross-sectional area of the support column 11 gradually decreases in a direction from the evaporation end to the condensation end.

It should be noted that specific sizes of cross-sectional areas of the first support column 111, the second support column 112, and the third support column 113 may be configured based on a heat dissipation requirement and a processing process. Optionally, the cross-sectional areas of the first support column 111, the second support column 112, and the third support column 113 range from 0.05 mm to 1 mm.

A person skilled in the art may understand that, regardless of the position at which the heat source 1000 is located relative to the vapor chamber, and regardless of a shape of the first housing 1, a size of the cross-sectional area of the support column 11 gradually decreases in the direction from the evaporation end to the condensation end.

The cross-sectional area of the support column 11 gradually decreases from the evaporation end to the condensation end, so that resistance at the evaporation end can be increased, and resistance at the condensation end can be reduced. When the resistance at two ends of the accommodating cavity is different, the gas working medium at the evaporation end can be rapidly diffused to the condensation end at which the resistance is smaller, so that the gas working medium is distributed more evenly in the evaporation cavity, and the gas working medium is distributed more widely. Therefore, a heat exchange area is large, so that the heat dissipation effect is ensured.

The first housing 1 in the foregoing embodiments is a rectangular member having a regular shape, and the shape of the first housing 1 is the shape of the vapor chamber. Therefore, the foregoing embodiments show a layout of the support columns 11 in a rectangular vapor chamber having a regular shape. In some embodiments, depending on a mounting space of an electronic device, there may be different shapes of vapor chambers, that is, different shapes of first housings 1.

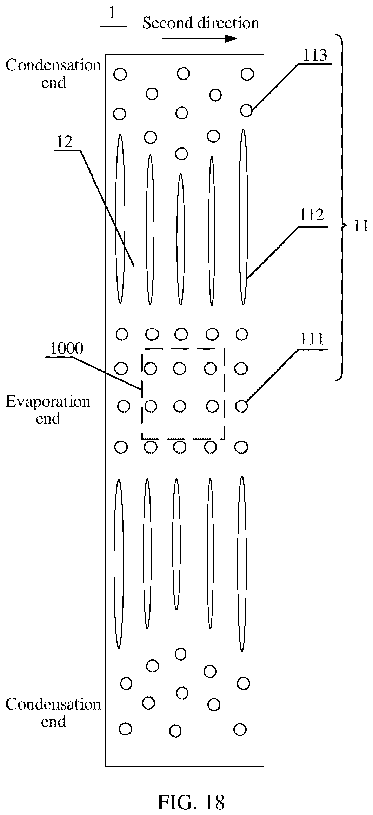

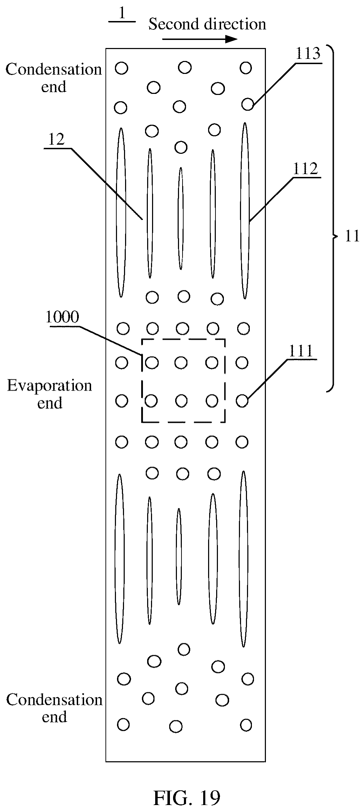

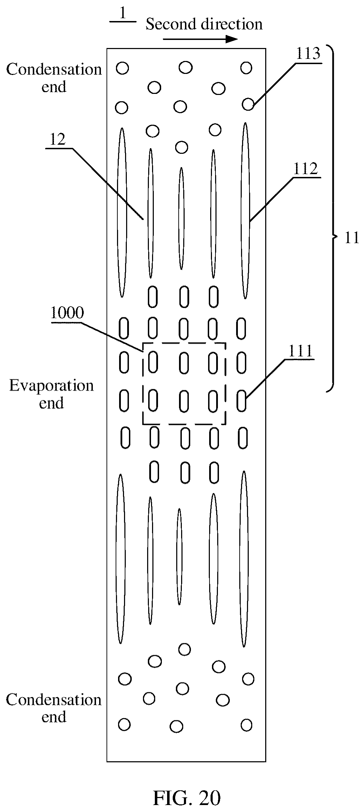

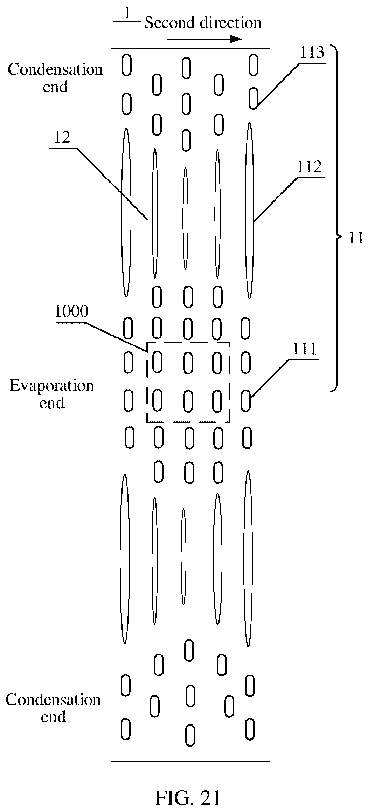

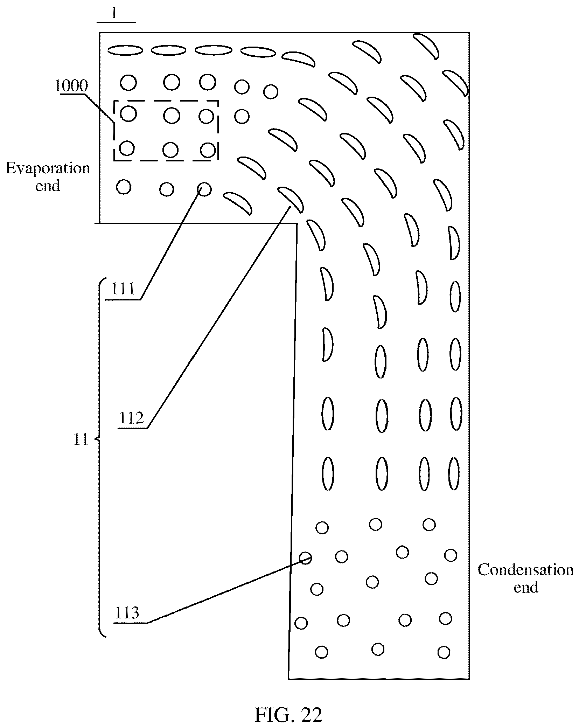

The following describes layouts of support columns 11 in vapor chambers of possible shapes with reference to FIG. 18 to FIG. 22. For a vapor chamber of another shape, refer to an arrangement principle of the support columns 11 in this specification. FIG. 18 is a schematic diagram of a tenth structure of a first housing. FIG. 19 is a schematic diagram of an eleventh structure of a first housing. FIG. 20 is a schematic diagram of a twelfth structure of a first housing. FIG. 21 is a schematic diagram of a thirteenth structure of a first housing. FIG. 22 is a schematic diagram of a fourteenth structure of a first housing.

As shown in FIG. 18 to FIG. 21, a vapor chamber corresponding to the first housing 1 is a narrow vapor chamber, and is mainly used in a scenario in which a width of the vapor chamber is equivalent to a size of a heat source 1000 or is slightly greater than a size of a heat source 1000. Optionally, a length-width ratio of the narrow vapor chamber is 5:1.

A middle position on the first housing 1 is close to the heat source 1000. Therefore, the middle position on the first housing 1 is an evaporation end, two ends of the first housing 1 are condensation ends, and middle segments are provided between the condensation ends and the evaporation end. Because the evaporation end is located in the middle, there are two condensation ends and also two middle segments. A gas working medium is divided into two paths from the evaporation end to the corresponding condensation ends.

First support columns 111 are cylindrical support columns, and are evenly arranged at the evaporation end. Second support columns 112 are airfoil-shaped support columns parallel to a first direction, and are arranged at the middle segment. Third support columns 113 are cylindrical support columns, and are arranged in a staggered manner at the condensation end.

It can be learned with reference to shapes of the airfoil-shaped support columns shown in FIG. 18 to FIG. 21 and FIG. 8 that when the first side surface 1123 and the second side surface 1124 in FIG. 8 are both arc surfaces, the airfoil-shaped support columns shown in FIG. 18 to FIG. 21 are the same. Therefore, the airfoil-shaped support columns in FIG. 18 to FIG. 21 also satisfy: a relationship between a chord length H and a maximum thickness D of the second support column 112 is D/H=0.05-0.95.

To meet a heat dissipation requirement of the narrow vapor chamber, manners of changing the layout of the support columns 11 or changing the shape of the support column 11 in all the foregoing embodiments may be used, and details are not described herein again. In this embodiment, the support column 11 is further used to guide a flow of the gas working medium, so that the gas working medium is distributed more evenly, thereby meeting the heat dissipation requirement.

As shown in FIG. 18, the evaporation end of the first housing 1 is located in the middle position, and the structure of the first housing 1 is described by using one side of the first housing 1 as an example. For the other side, refer to the descriptions below.

The second support columns 112 are only in one row in a second direction, and are symmetrically arranged with respect to the first direction. Lengths of the second support columns 112 are different, and the lengths of the second support columns 112 gradually increase from the middle to two sides of the first housing 1 in the second direction. Ends of the second support columns 112 close to the evaporation end are flush, and ends close to the condensation end are in different lengths.

In other words, in the second direction, a length of a vapor passage 12 close to the middle position on the first housing 1 at the middle segment is less than lengths of the vapor passages 12 at two ends of the first housing 1 at the middle segment.

Because the third support columns 113 are arranged in a staggered manner, under a disturbance action, resistance of a vapor passage 12 between the third support columns 113 is larger than resistance of a vapor passage 12 between the second support columns 112. The length of the vapor passage 12 close to the middle position at the middle segment is shortened, so that a gas working medium passing through the vapor passage 12 located in the middle position at the middle segment can reach the condensation end first. After the gas working medium reaches the condensation section, resistance of the vapor passage 12 located in the middle position on the condensation end may increase. In this way, some of the gas working medium flows from vapor passages 12 at two ends of the middle segment into a condensation end region, so that the gas working medium is distributed more evenly in an accommodating cavity, thereby effectively improving heat exchange efficiency.

It can be learned from the foregoing guiding function of the second support column 112 that the foregoing arrangement can avoid a problem of local overheating caused by local concentration of the gas working medium in the vapor chamber.

As shown in FIG. 19, the evaporation end of the first housing 1 is located in the middle position, and the structure of the first housing 1 is described by using one side of the first housing 1 as an example. For the other side, refer to the descriptions below.

The second support columns 112 are only in one row in a second direction, and are symmetrically arranged with respect to the first direction. Lengths of the second support columns 112 are different, and the lengths of the second support columns 112 gradually increase from the middle to two sides of the first housing 1 in the second direction. Ends of the second support columns 112 close to the evaporation end and ends of the second support columns 112 close to the condensation end are not flush. A line connecting ends of the second support columns 112 close to the first support column 111 and a line connecting ends of the second support columns 112 close to the third support column 113 are both V-shaped, and the second support columns 112 are symmetrically arranged with respect to the second direction.

It should be noted that a distance between the second support column 112 close to the evaporation end and an adjacent first support column 111 is the same. Therefore, in the second direction, a quantity of first support columns 111 close to a middle position at the evaporation end is greater than a quantity of first support columns 111 located at two ends at the evaporation end.

In other words, in the second direction, a length of a vapor passage 12 close to a middle position on the middle segment is less than lengths of vapor passages 12 at two ends of the middle segment, and a length of a vapor passage 12 close to the middle position on the evaporation end is greater than lengths of vapor passages 12 at two ends of the evaporation end.

The length of the vapor passage 12 close to the middle position on the evaporation end is increased, so that compared with the middle segment, a gas working medium in the middle position on the evaporation end can be diffused toward two sides of the evaporation end with smaller resistance. This facilitates diffusion of the gas working medium, to avoid a problem of local overheating caused by local concentration of the gas working medium in the vapor chamber.

For an arrangement of the ends of the second support columns 112 close to the condensation end in FIG. 19 and an effect generated, refer to the content of the second support columns 112 shown in FIG. 18. Details are not described herein again.

It can be learned from the arrangement of the first support columns 111 and the arrangement and a guiding function of the second support columns 112 that a problem of local overheating caused by local concentration of the gas working medium in the vapor chamber can be further avoided.

In the foregoing embodiments, the first support columns 111 and the third support columns 113 are both cylindrical support columns. In some embodiments, cross-sectional shapes of the first support column 111 and the third support column 113 may alternatively be changed, to reduce resistance of the first support column 111 and the third support column 113 to the gas working medium.

A narrow vapor chamber corresponding to the first housing 1 shown in FIG. 20 and FIG. 21 is used as an example for description.

As shown in FIG. 20 and FIG. 21, the support columns 11 are processed on the first housing 1, and the support columns 11 include the first support columns 111, the second support columns 112, and the third support columns 113. The middle position on the first housing 1 is close to the heat source 1000, and a position close to the heat source 1000 is the evaporation end, positions away from the heat source 1000 are the condensation ends, and the middle segments are provided between the condensation ends and the evaporation end.

The first support columns 111 are located at the evaporation end, the second support columns 112 are located at the middle segments, and the third support columns 113 are located at the condensation ends. For a cross-sectional shape and an arrangement manner of the second support column 112, refer to FIG. 19, and details are not described herein again.

The first support column 111 in FIG. 20 is a rectangular support column extending in a length direction of the first housing 1. Compared with a circular support column, the rectangular support column may further reduce resistance. Therefore, the first support column 111 is configured to be rectangular, so that efficiency of gas and liquid circulation can be improved, and a heat dissipation effect is ensured.

A cross-sectional shape of the first support column 111 includes, but is not limited to, a rectangle, and may alternatively be an ellipse, an airfoil-shaped, or the like, to reduce resistance of the first support column 111.

Based on the foregoing embodiment, a cross-sectional shape of the third support column 113 in FIG. 21 includes, but is not limited to, a rectangle, an ellipse, or an airfoil-shaped. An example in which the third support column 113 is a rectangular support column is used for description. Compared with a circular support column, the rectangular support column may further reduce resistance. Therefore, the third support column 113 is configured to be rectangular, so that efficiency of gas and liquid circulation can be improved, and a heat dissipation effect is ensured.

It should be noted that all shapes of the second support column 112 in this embodiment may be used for cross-sectional shapes of the first support column 111 and the third support column 113 in this specification.

A support column 11 disposed on an irregular-shaped first housing 1 is described below with reference to FIG. 22.

As shown in FIG. 22, the first housing 1 is an L-shaped member. One end of the L-shaped member is close to a heat source 1000, the end is an evaporation end, and the other end is a condensation end. First support columns 111 are disposed at the evaporation end, and the first support columns 111 are cylindrical support columns. Second support columns 112 are disposed at a middle segment, and the second support columns 112 are airfoil-shaped support columns. Third support columns 113 are disposed at the condensation end, and the third support columns 113 are cylindrical support columns arranged in a staggered manner.

A center line of the second support columns 112 is smoothly arranged along a trend of the L-shaped member, so that in a process in which a gas working medium flows from the evaporation end to the condensation end, resistance of the second support column 112 to the gas working medium can be reduced as the gas working medium flows along with a trend of the second support columns 112.

A shape of the second support column 112 is adaptively adjusted based on a flow trend of the gas working medium from the evaporation end to the condensation end.

It should be noted that all of the shapes of the support columns in this specification may be used for different shapes of the first housing 1 and different positions of the first housing 1 at which the heat source 1000 is located, for example, the airfoil-shaped support column and all arrangement manners. For example, a density of support columns close to the heat source 1000 is greater than a density of support columns away from the heat source 1000, and/or a size of a support column close to the heat source 1000 is larger than a size of a support column away from the heat source 1000, thereby ensuring a heat dissipation effect.

Shapes of the first support column 111, the second support column 112, and the third support column 113 herein may be randomly combined.

This application further discloses an electronic device, including a vapor chamber, and the vapor chamber is the vapor chamber disclosed in the foregoing embodiments. Therefore, the electronic device having the vapor chamber also has all the foregoing technical effects, which are not described herein again.

## Claims

1. A vapor chamber, comprising:

   a first housing and a second housing, wherein the first housing is sealingly connected to the second housing, and an accommodating cavity is formed between the first housing and the second housing; and
   support columns, wherein the support columns are fixed between the first housing and the second housing, a position on the first housing close to a heat source is an evaporation end, a position on the first housing away from the heat source is a condensation end, and
   a length of a cross section of at least part of the support columns is greater in a first direction than in a second direction, wherein the first direction is a direction from the evaporation end to the condensation end, and the second direction is perpendicular to the first direction.

2. The vapor chamber according to claim 1, wherein the support column having a cross section of which the length is greater in the first direction than in the second direction satisfies: a width of the support column first increases and then decreases in the first direction.

3. The vapor chamber according to claim 1, wherein the support columns comprise:

   first support columns, wherein the first support column is located at the evaporation end of the first housing;
   second support columns, wherein the second support column is located at a middle segment between the evaporation end and the condensation end, and a length of a cross section of the second support column is greater in the first direction than in the second direction; and
   third support columns, wherein the third support column is located at the condensation end of the first housing.

4. The vapor chamber according to claim 3, wherein the first support columns and the second support columns are arranged side by side in the first direction, and the third support columns are arranged in a staggered manner in the first direction and/or the second direction.

5. The vapor chamber according to claim 3 or 4, wherein a length of a cross section of the first support column and/or a length of a cross section of the third support column are/is greater in the first direction than in the second direction.

6. The vapor chamber according to claim 4 or 5, wherein at least one of the first support column, the second support column, and the third support column satisfies: a width first increases and then decreases in the first direction.

7. The vapor chamber according to any one of claims 3 to 6, wherein at least one of the first support column, the second support column, and the third support column is an airfoil-shaped support column, and a cross section of the airfoil-shaped support column comprises:

   a leading edge and a trailing edge, wherein both the leading edge and the trailing edge are arc surfaces, an opening angle of the leading edge is greater than an opening angle of the trailing edge, and the leading edge faces the heat source; and
   a first side and a second side, wherein the first side and the second side are respectively located at two sides of the leading edge and the trailing edge and connect the leading edge and the trailing edge.

8. The vapor chamber according to claim 7, wherein a chord length H of the cross section of the airfoil-shaped support column and a maximum thickness D of the airfoil-shaped support column satisfy: D/H=0.05-0.95.

9. The vapor chamber according to any one of claims 3 to 6, wherein at least one of the first support column, the second support column, and the third support column is a tapered support column, and a cross section of the tapered support column comprises:
   a first guide segment, a first connection segment, and a second guide segment that are connected in sequence, wherein in a direction from the first guide segment to the second guide segment, a width of the first guide segment gradually increases, a width of the second guide segment gradually decreases, and a width of the first connection segment is equal; and the first guide segment faces the heat source.

10. The vapor chamber according to claim 9, wherein the first guide segment is triangular, and a third guide segment is semi-elliptic or triangular.

11. The vapor chamber according to claim 9 or 10, wherein a cone angle of the first guide segment ranges from 20° to 80°.

12. The vapor chamber according to any one of claims 3 to 11, wherein in directions from the middle to two sides of the first housing in the second direction, lengths of vapor passages formed between adjacent second support columns in the first direction gradually increase.

**13.** The vapor chamber according to claim 12, wherein in the directions from the middle to two sides of the first housing in the second direction, lengths of the second support columns gradually increase.

**14.** The vapor chamber according to claim 13, wherein ends of a plurality of second support columns close to the first support column are flush, or a line connecting ends of a plurality of second support columns close to the first support column is V-shaped.

**15.** The vapor chamber according to claim 14, wherein the first support columns are evenly arranged in the first direction, and the third support columns are arranged in a staggered manner at the condensation end.

**16.** The vapor chamber according to any one of claims 1 to 14, wherein a density of the support columns gradually decreases in a direction away from the heat source.

**17.** The vapor chamber according to any one of claims 1 to 16, wherein a size of the support column gradually decreases in the direction away from the heat source.

**18.** The vapor chamber according to any one of claims 1 to 17, further comprising a capillary structure, wherein the capillary structure is located in the accommodating cavity.

**19.** An electronic device, comprising a vapor chamber, wherein the vapor chamber is the vapor chamber according to any one of claims 1 to 18.

FIG. 1

FIG. 2

100

01            011          012

Heat
source

02           1000         03

FIG. 3

01

012      1000

Evaporation
end

011

First
direction

Condensation
end

FIG. 4

FIG. 5

FIG. 6

FIG. 7

FIG. 8

FIG. 9

FIG. 10

FIG. 11

FIG. 12

Cylindrical support column

Elliptic support column

Spindle-shaped support column

First airfoil-shaped support column

Second airfoil-shaped support column

FIG. 13

24

FIG. 14

FIG. 15

FIG. 16

FIG. 17

FIG. 18

FIG. 19

FIG. 20

FIG. 21

FIG. 22

## INTERNATIONAL SEARCH REPORT

| International application No. |
|---|
| **PCT/CN2023/133587** |

| A. | CLASSIFICATION OF SUBJECT MATTER |
|---|---|

H05K 7/20(2006.01)i

According to International Patent Classification (IPC) or to both national classification and IPC

| B. | FIELDS SEARCHED |
|---|---|

Minimum documentation searched (classification system followed by classification symbols)

IPC: H05K

Documentation searched other than minimum documentation to the extent that such documents are included in the fields searched

Electronic data base consulted during the international search (name of data base and, where practicable, search terms used)

CNABS: CNTXT; VEN; USTXT; EPTXT; WOTXT; CNKI: 均热板, 均温板, 散热, 支撑, 蒸发, 冷凝, 横截面, 长度, 形状, 导流, 导向, 引导, 导引, VC, plate, heat, thermal, evaporation, steam, condensation, support, length, guide

| C. | DOCUMENTS CONSIDERED TO BE RELEVANT |
|---|---|

| Category* | Citation of document, with indication, where appropriate, of the relevant passages | Relevant to claim No. |
|---|---|---|
| X | CN 218570720 U (HONOR TERMINAL CO., LTD.) 03 March 2023 (2023-03-03) description, paragraphs [0002]-[0095], and figures 1-23 | 1-19 |
| X | CN 112996339 A (WANG XUNZHONG et al.) 18 June 2021 (2021-06-18) description, paragraphs [0002]-[0088], and figures 1A-5 | 1-19 |
| A | CN 115484788 A (DONGGUAN LINGYI PRECISION MANUFACTURING TECHNOLOGY CO., LTD.) 16 December 2022 (2022-12-16) entire document | 1-19 |
| A | JP 2008140831 A (SUMITOMO ELECTRIC INDUSTRIES, LTD.) 19 June 2008 (2008-06-19) entire document | 1-19 |

☐ Further documents are listed in the continuation of Box C.     ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **02 February 2024** | **14 February 2024** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2023/133587**

| Patent document cited in search report | | | Publication date (day/month/year) | Patent family member(s) | Publication date (day/month/year) |
|---|---|---|---|---|---|
| CN | 218570720 | U | 03 March 2023 | None | |
| CN | 112996339 | A | 18 June 2021 | None | |
| CN | 115484788 | A | 16 December 2022 | None | |
| JP | 2008140831 | A | 19 June 2008 | None | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202310478530